# EUROPÄISCHE PATENTSCHRIFT

(11) **EP 2 867 932 B1**
(45) Veröffentlichungstag und Bekanntmachung des Hinweises auf die Patenterteilung: **25.09.2019**
(21) Anmeldenummer: 13765467.9
(22) Anmeldetag: 02.07.2013
(51) Int. Cl.: H01L 51/44, H01L 51/52

(54) **TRANSPARENTE ELEKTRODE FÜR OPTOELEKTRONISCHE BAUELEMENTE**
TRANSPARENT ELECTRODE FOR OPTOELECTRONIC COMPONENTS
ÉLECTRODE TRANSPARENTE POUR COMPOSANTS OPTOÉLECTRONIQUES

(30) Priorität: 02.07.2012 DE 102012105809; 02.07.2012 DE 102012105810
(43) Veröffentlichungstag der Anmeldung: 06.05.2015
(73) Patentinhaber: Heliatek GmbH, 01139 Dresden (DE)
(72) Erfinder: PFEIFFER-JACOB, Martin, 01139 Dresden (DE); UHRICH, Christian, 01139 Dresden (DE); BEWERSDORFF-SARLETTE, Ulrike, 01139 Dresden (DE); MEIß, Jan, 81373 München (DE); LEO, Karl, 01219 Dresden (DE); RIEDE, Moritz, Oxford, OX2 6UD (GB); SCHUBERT, Sylvio, 01217 Dresden (DE); MÜLLER-MESKAMP, Lars, 01097 Dresden (DE)
(86) Internationale Anmeldenummer: PCT/IB2013/055425
(87) Internationale Veröffentlichungsnummer: WO 2014/006565

(56) Entgegenhaltungen:
- EP-A1- 1 909 341
- WO-A1-2009/136863
- WO-A1-2011/040388
- US-A1- 2009 223 559
- US-B1- 6 294 822
- US-B1- 6 576 093
- MEISS JAN ET AL: "Near-infrared absorbing semitransparent organic solar cells", APPLIED PHYSICS LETTERS, AIP, AMERICAN INSTITUTE OF PHYSICS, MELVILLE, NY, US, Bd. 99, Nr. 19, 7. November 2011 (2011-11-07), Seiten 193307-193307, XP012150411, ISSN: 0003-6951, DOI: 10.1063/1.3660708 [gefunden am 2011-11-11]
- Filmetrics ET AL: "Refractive Index of ITO, Indium Tin Oxide, InSnO for Thin Film Thickness Measurement", , 31 August 2016 (2016-08-31), XP055299004, Retrieved from the Internet: URL:http://www.filmetrics.com/refractive-i ndex-database/ITO/Indium-Tin- Oxide-InSnO [retrieved on 2016-08-31]

## Beschreibung

Die Erfindung betrifft eine transparente Elektrode für optoelektronische Bauelemente.

Optoelektronische Bauelemente, wie etwa Solarzellen oder LED's, TFT's, etc. finden heute eine breite Anwendung im alltäglichen sowie industriellen Umfeld. Von besonderem Interesse sind dabei solche Bauelemente, welche aufgrund ihrer Ausgestaltung eine Anordnung auf gekrümmten der gewölbten Oberflächen erlauben.

EP 1 909 341 A1 beschreibt eine Solarzelle, umfassend eine Anode, eine anorganische Schicht, eine Löchertransportschicht, eine photoaktive Schicht, eine Elektronentransportschicht und eine Kathode, die von einer Schutzschicht überzogen ist.

US 2009 223 559 A1 offenbart Laminate von Farbstoffsolarzellen. US 2009 223 559 A1 offenbart eine Antireflexionsschicht des Laminates, die über die komplette Solarzelle laminiert ist.

US 6 294 822 B1 offenbart nichtorganische, auf Silizium basierenden sphärische Halbleiterbauelemente, über die eine 1 bis 2 µm dicke Schutzschicht aus TiO₂ aufgebracht ist.

So sind beispielsweise Dünnschicht-Solarzellen bekannt, welche eine flexible Ausgestaltung aufweisen und damit eine Anordnung auf gekrümmten Oberflächen erlauben. Solche Solarzellen weisen dabei bevorzugt aktive Schichten aus amorphen Silicium (α-Si) oder CIGS (Cu(In,Ga)(S,Se)₂) auf. Nachteilig bei diesen Dünnschicht-Solarzellen sind die vor allem durch die Materialien bedingten hohen Produktionskosten.

Bekannt sind ebenfalls organische Leuchtdioden (OLED's), welche aufgrund der nicht benötigten Hintergrundbeleuchtung sehr dünn und damit auch flexibel ausgestaltet werden können. WO 2009 136 863 A1 beschreibt den Aufbau einer Kathode einer OLED, und US 6 576 093 B1 die Herstellung von OLEDs. EP 2 485 289 A1 beschreibt ein Polymer, und verwendet dieses in einer Polymerschicht, die zwischen den Elektroden einer Leuchtdiode eingebracht ist, zur Verbesserung der Lumineszenz der Leuchtdiode. Weiterhin bekannt sind auch Solarzellen mit organischen aktiven Schichten, welche flexibel ausgestaltet sind (Konarka - Power Plastic Series). Die organischen aktiven Schichten können dabei aus Polymeren (z.B. US 7 825 326 B2) oder kleinen Molekülen (z.B.

EP 2 385 556 A1) aufgebaut sein. Während Polymere sich dadurch auszeichnen, dass diese nicht verdampfbar und daher nur aus Lösungen aufgebracht werden können, sind kleine Moleküle verdampfbar.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm⁻¹), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Eine Solarzelle wandelt Lichtenergie in elektrische Energie um. Der Begriff photoaktiv bezeichnet hierbei ebenfalls die Umwandlung von Lichtenergie in elektrische Energie. Im Gegensatz zu anorganische Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluss beitragen.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht(en),
3. i- Schicht(en),
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) zumindest teilweise nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls- oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei Materialien (sogenannte interpenetrierende Netzwerke bzw. bulk-heterojunction; M. Hiramoto et al. Mol. Cryst. Liq. Cryst., 2006, 444, pp. 33-40) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004 083 958 A2 beschrieben sind. Als wide-gap Materialien werden hierbei Materialien bezeichnet, deren Absorptionsmaximum im Wellenlängenbereich < 450nm liegt, vorzugsweise bei < 400nm.

Da durch das Licht immer erst Exzitonen erzeugt werden und noch keine freien Ladungsträger, spielt die rekombinationsarme Diffusion von Exzitonen an die aktive Grenzfläche eine kritische Rolle bei organischen Solarzellen.

Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig. Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Aus der US 5 093 698 A ist die Dotierung organischer Materialien bekannt. Durch Beimischung einer akzeptorartigen bzw. donatorartigen Dotiersubstanz wird die Gleichgewichtsladungsträgerkonzentration in der Schicht erhöht und die Leitfähigkeit gesteigert. Nach US 5 093 698 A werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig.

Aus der Literatur sind verschiedene Realisierungsmöglichkeiten für die photoaktive i-Schicht bekannt. So kann es sich hierbei um eine Doppelschicht (EP 0 000 829 A1) oder eine Mischschicht (Hiramoto, Appl. Phys.Lett. 58,1062 (1991)) handeln. Bekannt ist auch eine Kombination aus Doppel-und Mischschichten (Hiramoto, Appl. Phys.Lett. 58,1062 (1991); US 6 559 375 B1). Ebenfalls bekannt ist, dass das Mischungsverhältnis in verschiedenen Bereichen der Mischschicht unterschiedlich ist (US 2005 110 005 A1) bzw. das Mischungsverhältnis einen Gradienten aufweist.

Weiterhin sind Tandem- bzw. Mehrfachsolarzellen aus der Literatur bekannt (Hiramoto, Chem. Lett., 1990, 327 (1990); DE 10 2004 014 046 A1).

Aus der Literatur schon lange bekannt sind organische Tandemsolarzellen (Hiramoto, Chem. Lett., 1990, 327 (1990)).

In der Tandemzelle von Hiramoto et al. befindet sich eine 2nm dicke Goldschicht zwischen den beiden Einzelzellen. Die Aufgabe dieser Goldschicht besteht darin für eine gute elektrische Verbindung zwischen den beiden Einzelzellen zu sorgen: die Goldschicht bewirkt eine effiziente Rekombination der Löcher aus der einen Teilzelle mit den Elektronen aus der anderen Teilzelle und bewirkt damit, dass die beiden Teilzellen elektrisch in Serie verschaltet sind. Weiterhin absorbiert die Goldschicht wie jede dünne Metallschicht (bzw. Metallcluster) einen Teil des einfallenden Lichts. Diese Absorption ist in der Tandemzelle von Hiramoto ein Verlustmechanismus, da dadurch den photoaktiven Schichten (H2Pc (metallfreies Phthalocyanin)/ Me-PTC (N,N"-dimethylperylene-3,4,9,10-bis(dicarboximide) in den beiden Einzelzellen der Tandemzelle weniger Licht zur Verfügung steht. Die Aufgabe der Goldschicht ist in dieser Tandemstruktur daher rein auf der elektrischen Seite. Innerhalb dieser Konzeption sollte die Goldschicht möglichst dünn sein bzw. im besten Fall komplett wegfallen.

Weiterhin aus der Literatur bekannt sind organische pin-Tandemzellen (DE 10 2004 014 046 A1): Die Struktur solch einer Tandemzelle besteht aus zwei pin-Einzelzellen wobei die Schichtfolge "pin" die Abfolge aus einem p-dotierten Schichtsystem, einem undotierten photoaktiven Schichtsystem und einem n-dotierten Schichtsystem beschreibt. Die dotierten Schichtsysteme bestehen bevorzugt aus transparenten Materialien, so genannten wide-gap Materialien/Schichten und sie können hierbei auch teilweise oder ganz undotiert sein oder auch ortsabhängig verschiedene Dotierungskonzentrationen aufweisen bzw. über einen kontinuierlichen Gradienten in der Dotierungskonzentration verfügen. Speziell auch sehr gering dotierte oder hochdotierte Bereiche im Grenzbereich an den Elektroden, im Grenzbereich zu einer anderen dotierten oder undotierten Transportschicht, im Grenzbereich zu den aktiven Schichten oder bei Tandem- oder Mehrfachzellen im Grenzbereich zu der anliegenden pin- bzw. nip- Teilzelle, d.h. im Bereich der Rekombinationszone sind möglich. Auch eine beliebige Kombination aus allen diesen Merkmalen ist möglich. Natürlich kann es sich bei einer solchen Tandemzelle auch um eine sogenannte invertierte Struktur (z.B. nip-Tandemzelle) handeln. Im Folgenden werden alle diese möglichen Tandemzellen-Realisierungsformen mit dem Begriff pin-Tandemzellen bezeichnet. Ein Vorteil einer solchen pin-Tandemzelle besteht darin, dass durch die Verwendung von dotierten Transportschichten eine sehr einfache und gleichzeitig sehr effiziente Realisierungsmöglichkeit für die Rekombinationszone zwischen den beiden Teilzellen möglich ist. Die Tandemzelle weist z.B. eine pinpin-Struktur auf (oder auch z.B. möglich nipnip). An der Grenzfläche zwischen den beiden pin-Teilzellen befinden sich jeweils eine n-dotierte Schicht und eine p-dotierte Schicht, die ein pn-System (bzw. np-System) bilden. In einem solchen dotierten pn-System erfolgt eine sehr effiziente Rekombination der Elektronen und Löcher. Die Stapelung von zwei pin-Einzelzellen ergibt damit direkt eine vollständige pin-Tandemzelle, ohne dass noch weitere Schichten benötigt werden. Speziell von Vorteil ist hier, dass keine dünnen Metallschichten mehr benötigt werden wie bei Hiramoto, um die effiziente Rekombination zu gewährleisten. Hierdurch kann die Verlustabsorption solcher dünnen Metallschichten komplett vermieden werden.

Die bisher in der Literatur beschriebenen Topkontakte sind zur Realisierung optoelektronischer Bauelemente mit hoher Transparenz nicht ausreichend und weisen zu hohe Reflexionen auf. Weiterhin besteht ein hohes Interesse an der Realisierung transparenter Topkontakte auf opaken Substraten.

Zur Realisierung von transparenten Topkontakten auf organischen Bauelementen sind aus der Literatur dünne thermisch aufgedampfte Metallschichten mit Zwischenschichten und gesputterte ITO Schichten bekannt.

Bailey-Salzmann et al. zeigen in ihrer Veröffentlichung von 2006 (APPLIED PHYSICS LETTERS 88, 233502 (2006)) die Verwendung von dünnen Ag Schichten (25nm) zu Realisierung von semitransparenten organischen Solarzellen.

Meiss et al. zeigen 2009 in ihrer Veröffentlichung (APPLIED PHYSICS LETTERS 95, 213306 (2009)) die Verwendung von dotierten Transportschichten und dünnen Ag Schichten (14nm) zur Realisierung von transparenten organischen Solarzellen. Darüber hinaus wird in dieser Veröffentlichung eine dünne Al Zwischenschicht unter der Ag Schicht zur Glättung selbiger verwendet. Auch die Verwendung von organischen Schichten auf der dünnen Ag Schicht zur Erhöhung der Transparenz des Top-Kontaktes wird hier gezeigt.

In ihrer Veröffentlichung von 2011 zeigen Meiss et. al (APPLIED PHYSICS LETTERS 99, 193307, 2011) alternativ zu der zuvor beschriebenen dünnen Al Zwischenschicht die Verwendung von einer dünnen Ca Schicht.

Aus der Literatur ist auch die Realisierung von organischen Bauelementen mit transparentem TopKontakt auf opaken Grundkontakt bekannt. Hofmann et al. zeigen beispielsweise in ihrer Veröffentlichung (APPLIED PHYSICS LETTERS 97, 253308, 2010) eine organische Leuchtdiode (OLED) unter Verwendung von dotierten Transportschichten, einer dünnen Ag-Metallschicht (13nm) und einer organischen Schicht auf der Ag-Schicht zur Erhöhung der Transparenz des Top-Kontaktes.

Bei opaken Substraten führen die bekannten Lösungen zu verstärkter parasitärer Absorption und Reflexionsverlusten und damit zu einer Verringerung der Effizienz gegenüber transparenten Substraten, wie etwa mit ITO-Grundkontakten. Die Aufgabe der vorliegenden Erfindung besteht daher darin, die vorbenannten Nachteile des Stands der Technik zu überwinden und einen transparenten Topkontakt für optoelektronische Bauelemente anzugeben.

Die Aufgabe wird durch ein Bauelement gemäß dem Anspruch 1 gelöst. Vorteilhafte Ausgestaltungen sind in den abhängigen Ansprüchen angegeben.

Erfindungsgemäß umfasst ein optoelektronisches Bauelement auf einem Substrat eine erste und eine zweite Elektrode, wobei die erste Elektrode auf dem Substrat angeordnet ist und die zweite Elektrode eine Gegenelektrode bildet, wobei zwischen diesen Elektroden zumindest ein photoaktives Schichtsystem angeordnet ist, welches zumindest ein Donor-Akzeptorsystem mit organischen Materialien und eine dotierte, teilweise dotierte Transportschicht, d.h. eine n- bzw. p-schicht, umfasst, wobei die Gegenelektrode zumindest eine erste Schicht umfassend eine Metalllegierung, die Ag enthält, aufweist. Weiterhin umfasst die Gegenelektrode eine erste Zwischenschicht aus einem Alkali- oder Erdalkalimetall, oder MoOx, wobei die erste Zwischenschicht zwischen der ersten Schicht und dem photoaktiven Schichtsystem des Bauelements angeordnet ist. Zudem umfasst die Gegenelektrode eine zweite Schicht, welche auf der ersten Schicht angeordnet ist und eine Schichtdicke zwischen 10 bis 100 nm und einen Brechungsindex größer 2,0 aufweist. Weiterhin ist eine Transportschicht zwischen photoaktivem Donor-Akzeptorsystem und Gegenelektrode angeordnet.

In einer weiteren Ausführungsform der Erfindung umfasst die erste Schicht ein Alkali- oder Erdalkalimetall, ein Metalloxid.

In einer Ausführungsform der Erfindung enthält die erste Schicht eine Legierung aus Ag und Ca oder Ag und Mg.

In einer Ausführungsform der Erfindung enthält die Schicht eine Legierung aus Ag und Ca oder Ag und Mg enthält, wobei der Anteil des Ag oder Ca oder Mg mindestens 30% beträgt. In einer weiteren Ausführungsform weist die erste Zwischenschicht eine Schichtdicke von 0,05 bis 30 nm auf. In einer weiteren Ausführungsform enthält die erste Zwischenschicht Ca oder MoOₓ.

In einer weiteren Ausführungsform umfasst die erste Zwischenschicht ein Alkali oder Erdalkalimetallhalogenid.

In einer weiteren Ausführungsform der Erfindung umfasst die zweite Schicht ein Alkali- oder Erdalkalimetall, ein Metalloxid oder ein organisches Material.

In einer weiteren Ausführungsform der Erfindung ist auf der zweiten Schicht eine Schutzschicht angeordnet, welche ein Metalloxid umfasst und eine Schichtdicke > 100 nm aufweist. Die Schutzschicht dient dabei beispielsweise als Kratzschutz.

In einer weiteren Ausführungsform der Erfindung ist das Substrat opak oder transparent ausgeführt.

Unter opak wird im Sinne der Erfindung nicht transparent verstanden.

In einer weiteren Ausführungsform der Erfindung ist das Substrat flexibel ausgeführt.

Unter einem flexiblen Substrat wird im Sinne der vorliegenden Erfindung ein Substrat verstanden, welches eine Verformbarkeit infolge äußerer Krafteinwirkung gewährleistet. Dadurch sind solche flexiblen Substrate zur Anordnung auf gekrümmten Oberflächen geeignet. Flexible Substrate sind beispielsweise Folien oder Metallbänder

In einer weiteren Ausführungsform der Erfindung ist das Substrat flexibel ausgeführt.

In einer weiteren Ausführungsform der Erfindung ist die Elektrode, welche auf dem Substrat angeordnet ist opak oder transparent ausgeführt.

In einer weiteren Ausführungsform der Erfindung umfasst die Elektrode, welche auf dem Substrat angeordnet, ein Metall, Metalloxid, Metallgrid, Metall-Metalloxid-Schichtsystem, Metallpartikel, Metallnanowire, Graphen, organische Halbleiter.

In einer ersten Ausführungsform der Erfindung weist die erste Zwischenschicht der Gegenelektrode eine Schichtdicke zwischen 0,1 bis 100 nm auf und ist durch thermisches Verdampfen abgeschieden. Dies ist insbesondere vorteilhaft, wenn metallische Schichten oder Metalloxidschichten auf organischen Schichten oder Schichten enthaltend organische Materialien abgeschieden werden sollen.

Unter thermischen Verdampfen wird im Sinne der vorliegenden Erfindung das Aufheizen des zu verdampfenden Materials in einer Verdampfungseinrichtung verstanden, wobei das Material erhitzt und infolgedessen verdampft wird, sodass ein Materialdampf entsteht, wobei sich dieser Materialdampf auf einem Substrat, das in räumlicher Nähe zur Verdampfungseinrichtung angeordnet ist, als Schicht abscheidet.

In einer Ausführungsform der Erfindung weist die erste Schicht eine Schichtdicke zwischen 0,5 und 30 nm auf.

In einer Ausführungsform der Erfindung ist die erste Schicht durch thermisches Verdampfen abgeschieden und weist eine Schichtdicke zwischen 0,5 bis 20 nm auf.

In einer weiteren Ausführungsform enthält die erste Zwischenschicht ein Molybdänoxid ausgewählt aus der Gruppe MoO, MoO₂ und MoO₃.

In einer weiteren Ausführungsform der Erfindung weist die erste Schicht der Gegenelektrode eine Schichtdicke zwischen 3 und 20 nm, vorzugsweise 5 bis 10 nm auf und ist nicht durch thermisches Verdampfen abgeschieden. Alternative Abscheidemethoden im Vergleich zu thermischen Verdampfen, welche nachfolgend als Depositionstechniken bezeichnet werden, können z.B. Elektronenstrahlverdampfen (engl. electron beam evaporation), Laserstrahlverdampfen (engl. pulsed laser deposition, pulsed laser ablation), Lichtbogenverdampfen (engl. arc evaporation, Arc-PVD, Molekularstrahlepitaxie (engl. molecular beam epitaxy), Sputtern (Sputterdeposition, Kathodenzerstäubung), Ionenstrahlgestützte Deposition (engl. ion beam assisted deposition, IBAD), Ionenplattieren, ICB-Technik (engl. ionized cluster beam deposition, ICBD) sein. Die Abscheidung der ersten Schicht durch alternative Abscheidemethoden im Vergleich zu thermischen Verdampfen vereint mehrere Vorteile in sich:
1) Gegenüber thermischen Verdampfen können mit Hilfe von alternativen Abscheidemethoden glattere Schichten erzeugt werden, so dass bereits bei sehr dünnen Schichten eine geschlossene Schicht mit hoher Leitfähigkeit in der Ebene des Substrates erreicht werden kann. Auf Grund der geringen Schichtdicke können hohe Transmissionen der Schicht erreicht werden, bei gleichzeitig ausreichender Leitfähigkeit (in der Ebene).
2) Gegenüber thermischen Verdampfen kann mit Hilfe der oben benannten Depositionstechniken ein hohes Maß an Homogenität der Schichtdicke auf dem Substrat erzeugt werden. Dies ist bei dünnen Top-Kontakt-Schichten besonders wichtig, da sich Schwankungen in der Schichtdicke der zweiten Schicht direkt auf die Leistung des Bauelements auswirken und zu einer sichtbaren Änderung des optischen Eindrucks des Bauelements führen, was im Allgemeinen unerwünscht ist.
3) Durch die Verwendung von alternativen Abscheidemethoden gegenüber dem thermischen Verdampfen, ist es möglich eine größere Anzahl von verschiedenen Materialien bei großer Variation der Prozessparameter (z.B. reaktives Sputtern) zu verwenden.

In einer weiteren Ausführungsform der Erfindung weist die zweite Schicht eine Schichtdicke zwischen 10 bis 100 nm auf und ist durch thermisches Verdampfen oder alternativen Abscheidemethoden abgeschieden. Die zweite Schicht dient in erster Linie zur Dünnschicht-Entspiegelung des Top-Kontaktes und sollte einen höheren Brechungsindex als das angrenzende, der zweiten Schicht nachfolgende Medium in dem für die Solarzelle nutzbaren Wellenlängenbereich besitzen.

In einer weiteren Ausführungsform der Erfindung weist die zweite Schicht einen Brechungsindex > 2,2 auf. Dies ist insbesondere vorteilhaft, um einen höheren Brechungsindex in dem für die Solarzelle nutzbaren Wellenlängenbereich gegenüber nachfolgenden Kleberschichten sicherzustellen. Beispielhafte Verbindungen mit einem Brechungsindex > 2 sind etwa Selenide, Sulfide, Telluride, Nitride, Polymere, wie beispielsweise ZnS, ZnSe, ZnTe.

In einer weiteren Ausführungsform der Erfindung ist auf der zweiten Schicht eine Schutzschicht, welche ein Metalloxid umfasst, angeordnet, welche eine Schichtdicke > 100 nm aufweist. Diese Schutzschicht bietet dem Bauelement einen mechanischen Schutz, so dass die Berührung der aktiven Seite ermöglicht wird und/ oder realisiert einen verstärkten Schutz des organischen Bauelements vor insbesondere Wasser und Sauerstoff.

In einer weiteren Ausführungsform der Erfindung ist zwischen der ersten Zwischenschicht und der ersten Schicht der Gegenelektrode zumindest eine zweite Zwischenschicht aus einem Metall oder Metalloxid eingefügt, welche eine Schichtdicke zwischen 0,02 bis 40 nm aufweist. Diese zweite Zwischenschicht kann als Glättungsschicht oder als Benetzungsschicht (wetting-layer) oder Keimschicht (Seedlayer) fungieren.

In einer Ausgestaltung der zweiten Zwischenschicht als Glättungsschicht wird die Rauigkeit von unterliegenden Schichten ausgeglichen, so dass die leitfähige erste Schicht auf der durch die zweite Zwischenschicht geglätteten ersten Zwischenschicht aufwächst, wobei eine ausreichende Leitfähigkeit bei bereits geringen Schichtdicken der ersten Schicht erreicht wird.

In einer Ausgestaltung der zweiten Zwischenschicht als Benetzungsschicht verhindert bzw. vermindert diese das Inselwachstum der ersten Schicht, so dass bereits bei geringen Schichtdicken der ersten Schicht eine ausreichende Leitfähigkeit in der Ebene des Substrates erzeugt wird. In einer Ausgestaltung der zweiten Zwischenschicht als Keimschicht kann das Inselwachstum zwar nicht unterbunden werden, aber bei Deposition der ersten Schicht bilden sich Inseln an den Keimen der Keimschicht, die sehr dicht nebeneinander liegen, so dass bei geringen Schichtdicken der ersten Schicht eine ausreichende Leitfähigkeit in der Ebene des Substrates erzeugt wird.

Die zweite Zwischenschicht kann beispielsweise mittels der oben genannten Depositionstechniken abgeschieden werden.

In einer Ausgestaltung der Ausführungsform ist die zweite Zwischenschicht aus mehreren Schichten mit unterschiedlicher Materialzusammensetzung ausgeführt. Die zweite Zwischenschicht kann zudem aus einem leitfähigen Material oder einer Mischung von Materialien ausgeführt sein. Es ist zudem denkbar, dass diese Schicht zur Stressreduktion zwischen den Schichten des Bauelements beiträgt. Solcher Stress zwischen den Schichten kann beispielsweise auf Grund von unterschiedlichen Wärmeausdehnungskoeffizienten (Dehnungskoeffizienten o.ä.) auftreten, was im schlimmsten Fall zu einem teilweisen oder vollständigen Ablösen der Schichten führen kann.

In einer weiteren Ausführungsform der Erfindung ist zwischen der ersten und der zweiten Schicht der Gegenelektrode eine dritte Zwischenschicht mit einer Schichtdicke zwischen 0,02 nm und 40 nm aus einem Metall oder Metalloxid eingefügt. Diese dritte Zwischenschicht kann als Glättungsschicht, Benetzungsschicht oder Keimschicht fungieren. Die dritte Zwischenschicht kann mittels einer der oben benannten Depositionstechniken oder thermischen abgeschieden sein. In einer Ausgestaltung der Ausführungsform ist die dritte Zwischenschicht aus mehreren Schichten mit unterschiedlicher Materialzusammensetzung ausgeführt. Die dritte Zwischenschicht kann zudem aus einem leitfähigen Material oder einer Mischung von Materialien ausgeführt sein. Es ist zudem denkbar, dass diese dritte Zwischenschicht zur Stressreduktion beiträgt.

In einer weiteren Ausführungsform der Erfindung umfasst die zweite Schicht ein Alkali- oder Erdalkalimetall, ein Metalloxid oder ein organisches Material.

In einer weiteren Ausführungsform der Erfindung umfasst die zweite Schicht ein Nitrid, Selenid, Sulfid, Oxid, Tellurid oder Polymer umfasst.

In einer weiteren Ausführungsform der Erfindung umfasst die zweite Schicht Ag, Au, Pt, Cr, Ti, Al, Zr, Cu, Zn, Sn, Sr, La, In, Sc, Hf oder eine Legierungen umfassend zumindest eines der vorbenannten Elemente.

In einer weiteren Ausführungsform der Erfindung handelt es sich bei dem Bauelement um eine pin-Einzel, pin-Tandemzelle, pin-Mehrfachzelle, nip-Einzelzelle, nip- Tandemzelle oder nip-Mehrfachzelle.

In einer weiteren Ausführungsform der Erfindung ist das Bauelement aus einer Kombination aus nip, ni, ip, pnip, pni, pip, nipn, nin, ipn, pnipn, pnin oder pipn-Strukturen ausgeführt, bei der mehrere unabhängige Kombinationen, die mindestens eine i-Schicht enthalten, übereinander gestapelt sind.

In einer weiteren Ausführungsform der Erfindung umfasst die aktive Schicht mindestens eine Mischschicht mit mindestens zwei Hauptmaterialien, wobei diese ein photoaktives Donor-Akzeptor-System bilden.

In einer weiteren Ausführungsform der Erfindung ist zumindest ein Hauptmaterial ein organisches Material.

In einer weiteren Ausführungsform der Erfindung handelt es sich bei dem organischen Material um kleine Moleküle. Unter dem Begriff kleine Moleküle werden im Sinne der Erfindung Monomere verstanden, die verdampft und damit auf dem Substrat abgeschieden werden können.

In einer weiteren Ausführungsform der Erfindung handelt es sich bei dem organischen Material zumindest teilweise um Polymere.

In einer weiteren Ausführungsform der Erfindung umfasst mindestens eine der aktiven Mischschichten als Akzeptor ein Material aus der Gruppe der Fullerene bzw. Fullerenderivate. In einer weiteren Ausführungsform der Erfindung ist zwischen der Elektrode und der Gegenelektrode zumindest eine dotierte, teilweise dotierte oder undotierte Transportschicht angeordnet.

Erfindungsgemäß ist zwischen der Gegenelektrode und dem photoaktiven Schichtsystem eine dotierte, teilweise dotierte oder undotierte Transportschicht angeordnet.

In einer weiteren Ausführungsform der Erfindung ist das optoelektronsiche Bauelement eine organische Solarzelle.

In einer weiteren Ausführungsform der Erfindung ist das optoelektronische Bauelement eine organische Leuchtdiode.

In einer weiteren Ausführungsform der Erfindung weist das optoelektronische Bauelement zwischen der Elektrode und der Gegenelektrode mehr als eine photoaktive Schicht auf.

In einer weiteren Ausführungsform der Erfindung bestehen die Mischschichten bevorzugt aus jeweils zwei Hauptmaterialien.

In einer weiteren Ausführungsform der Erfindung kann in den einzelnen Mischschichten ein Gradient des Mischungsverhältnisses vorhanden sein.

In einer weiteren Ausführungsform der Erfindung sind eine oder mehrere der weiteren organischen Schichten dotierte wide-gap Schichten, wobei das Maximum der Absorption bei < 450nm liegt.

In einer weiteren Ausführungsform der Erfindung weisen mindestens zwei Hauptmaterialien der Mischschichten verschiedene optische Absorptionsspektren auf.

In einer weiteren Ausführungsform der Erfindung weisen die Hauptmaterialien der Mischschichten verschiedene optische Absorptionsspektren auf, die sich gegenseitig ergänzen, um einen möglichst breiten Spektralbereich abzudecken.

In einer weiteren Ausführungsform der Erfindung erstreckt sich der Absorptionsbereich zumindest eines der Hauptmaterialien der Mischschichten in den Infrarot-Bereich.

In einer weiteren Ausführungsform der Erfindung erstreckt sich der Absorptionsbereich zumindest eines der Hauptmaterialien der Mischschichten in den Infrarot-Bereich im Wellenlängenbereich von >700nm bis 1500nm.

In einer weiteren Ausführungsform der Erfindung sind die HOMO- und LUMO-Niveaus der Hauptmaterialien so angepasst, dass das System eine maximale Leerlaufspannung, einen maximalen Kurzschlussstrom und einen maximalen Füllfaktor ermöglicht.

In einer weiteren Ausführungsform der Erfindung enthält mindestens eine der photoaktiven Mischschichten als Akzeptor ein Material aus der Gruppe der Fullerene bzw. Fullerenderivate (C₆₀, C₇₀, etc.).

In einer weiteren Ausführungsform der Erfindung enthalten alle photoaktiven Mischschichten als Akzeptor ein Material aus der Gruppe der Fullerene bzw. Fullerenderivate (C₆₀, C₇₀, etc.).

In einer weiteren Ausführungsform der Erfindung enthält mindestens eine der photoaktiven Mischschichten als Donator ein Material aus der Klasse der Phthalocyanine, Perylenderivate, TPD-Derivate, Oligothiophene oder ein Material wie es in WO 2006 092 134 A1 beschrieben ist.

In einer weiteren Ausführungsform der Erfindung enthält mindestens eine der photoaktiven Mischschichten als Akzeptor das Material Fulleren C₆₀ und als Donator das Material 4P-TPD.

Im Sinne der Erfindung sind auch Polymersolarzellen, die zwei oder mehrere photoaktive Mischschichten beinhalten, umfasst, wobei die Mischschichten direkt aneinandergrenzen. Bei Polymersolarzellen besteht aber das Problem, dass die Materialien aus Lösung aufgebracht werden und somit eine weitere aufgebrachte Schicht sehr leicht dazu führt, dass die darunter liegenden Schichten angelöst, aufgelöst oder in ihrer Morphologie verändert werden. Bei Polymersolarzellen können daher nur sehr eingeschränkt Mehrfachmischschichten hergestellt werden und auch nur dadurch, dass verschiedene Material- und Lösungsmittelsysteme verwendet werden, die sich bei der Herstellung gegenseitig nicht oder kaum beeinflussen. Solarzellen aus kleinen Molekülen haben hier einen ganz klaren Vorteil, da durch den Aufdampfprozess im Vakuum beliebige Systeme und Schichten aufeinander gebracht werden können und somit der Vorteil der Mehrfachmischschichtstruktur sehr breit genutzt und mit beliebigen Materialkombinationen realisiert werden kann.

In einer weitere Ausführungsform der Erfindung ist zwischen der ersten elektronenleitenden Schicht (n-Schicht) und der auf dem Substrat befindlichen Elektrode noch eine p-dotierte Schicht vorhanden ist, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung ist in dem Bauelement zwischen der aktiven Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportniveaus der i-Schicht liegt, so dass es zu verlustarmer Elektronenextraktion aus der i-Schicht in diese p-Schicht kommen kann.

In einer weiteren Ausführungsform der Erfindung ist noch ein n-Schichtsystem zwischen der p-dotierten Schicht und der Gegenelektrode vorhanden, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt, so dass es zu verlustarmer Löcherextraktion aus der i-Schicht in diese n-Schicht kommen kann.

In einer weiteren Ausführungsform verfügt das Akzeptor-Material über ein Absorptionsmaximum im Wellenlängenbereich > 450nm.

In einer weiteren Ausführungsform verfügt das Donator-Material über ein Absorptionsmaximum im Wellenlängenbereich > 450nm.

In einer weiteren Ausführungsform enthält das aktive Schichtsystem zusätzlich zu der genannten Mischschicht noch weitere photoaktive Einzel- oder Mischschichten.

In einer weiteren Ausführungsform enthält das n-Materialsystem eine oder mehrere dotierte wide-gap Schichten. Der Begriff wide-gap Schichten definiert dabei Schichten mit einem Absorptionsmaximum im Wellenlängenbereich < 450nm.

In einer weiteren Ausführungsform enthält das p-Materialsystem eine oder mehrere dotierte wide-gap Schichten.

In einer weiteren Ausführungsform ist das Akzeptor-Material ein Material aus der Gruppe der Fullerene bzw. Fullerenderivate (bevorzugt C₆₀ oder C₇₀) oder ein PTCDI-Derivat (Perylen-3,4,9,10-bis(dicarboximid)-Derivat).

In einer weiteren Ausführungsform ist das Donator-Material ein Oligomer, insbesondere ein Oligomer nach WO 2006 092 134 A1, ein Porphyrin-Derivat, ein Pentacen-Derivat oder ein Perylenderivat, wie DIP (Di-Indeno-*Perylen*), DBP (Di-benzo-perylene).

In einer weiteren Ausführungsform enthält das p-Materialsystem ein TPD-Derivat(Triphenylamin-Dimer), eine Spiro-Verbindung, wie Spiropyrane, Spiroxazine, MeO-TPD (N,N,N',N'-Tetrakis(4-methoxyphenyl)-benzidin), Di-NPB (N,N'diphenyl-N,N'-bis(N,N'-*di*(1-naphthyl)-N,N'-diphenyl-(1,1'-biphenyl)4,4'-diamine), MTDATA (4,4',4"-Tris-(N-3-methylphenyl-N-phenyl-amino)-triphenylamin), TNATA (4,4',4"-Tris[N-(1-naphthyl)-N-phenyl-aminol-triphenylamin), BPAPF (9,9-bis{4-[di-(p-biphenyl)aminophenyl]}fluorene), NPAPF (9,9-Bis[4-(N,N'-bis-naphthalen-2-yl-amino)phenyl]-9H-fluorene), Spiro-TAD (2,2',7,7'-Tetrakis-(diphenylamino)-9,9'-spirobifluoren), PV-TPD (N,N-di 4-2,2-diphenyl-ethen-1-yl-phenyl-N,N-di 4-methylphenylphenylbenzidine), 4P-TPD (4,4'-bis-(N,N-diphenylamino)-tetraphenyl), oder ein in
DE 10 2004 014 046 A1 beschriebenes p-Material.

In einer weiteren Ausführungsform enthält das n-Materialsystem Fullerene, wie beispielsweise C₆₀, C₇₀; NTCDA (1,4,5,8-Naphthalene-tetracarboxylic-dianhydride), NTCDI (Naphthalenetetracarboxylic diimide) oder PTCDI (Perylen-3,4,9,10-bis(dicarboximid).

In einer weiteren Ausführungsform enthält das p-Materialsystem einen p-Dotanden, wobei dieser p-Dotand F4-TCNQ, ein p-Dotand wie in DE 103 38 406 A1, DE 103 47 856 A1, DE 103 57 044 A1, DE 10 2004 010 954 A1, DE 10 2006 053 320 A1, DE 10 2006 054 524 A1 und DE 10 2008 051 737 A1 beschrieben oder ein Übergangsmetalloxid (VO, WO, MoO, etc.) ist.

In einer weiteren Ausführungsform enthält das n-Materialsystem einen n-Dotanden, wobei dieser n-Dotand ein TTF-Derivat (Tetrathiafulvalen-Derivat) oder DTT-Derivat (dithienothiophen), ein n-Dotand wie in DE 103 38 406 A1, DE 103 47 856 A1, DE 103 57 044 A1, DE 10 2004 010 954 A1, DE 10 2006 053 320 A1, DE 10 2006 054 524 A1 und DE 10 2008 051 737 A1 beschrieben oder Cs, Li oder Mg ist.

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform weisen die verwendeten organischen Materialien einen niedrigen Schmelzpunkt, bevorzugt < 100°C, auf.

In einer weiteren Ausführungsform weisen die verwendeten organischen Materialien eine niedrige Glasübergangstemperatur, bevorzugt < 150°C, auf.

In einer weiteren Ausführungsform werden die erfindungsgemäßen optoelektronischen Bauelemente in Verbindung mit Energiepuffer bzw. Energiespeichermedium wie beispielsweise Akkus, Kondensatoren, etc. zum Anschluss an Verbraucher bzw. Geräte verwendet.

In einer weiteren Ausführungsform werden die erfindungsgemäßen optoelektronischen Bauelemente in Kombination mit Dünnfilmbatterien verwendet.

In einer weiteren Ausführungsform werden die erfindungsgemäßen optoelektronischen Bauelemente auf gekrümmten Oberflächen, wie beispielsweise Glas, Beton, Dachziegeln, Ton, Autoglas, etc. verwendet. Dabei ist es vorteilhaft, dass die erfindungsgemäßen organischen Solarzellen gegenüber herkömmlichen anorganischen Solarzellen auf flexiblen Trägern wie Folien, Textilen, etc. aufgebracht werden können.

Zur Realisierung der Erfindung können auch die vorbeschriebenen Ausführungsformen miteinander kombiniert werden.

Nachfolgend soll die Erfindung anhand einiger Ausführungsbeispiele und Figuren eingehend erläutert werden. Die Ausführungsbeispiele sollen dabei die Erfindung beschreiben ohne diese zu beschränken. Es zeigen in
Fig. 1 eine schematische Darstellung einer ersten erfindungsgemäßen Ausführung einer Gegenelektrode in,
Fig. 2 eine schematische Darstellung einer zweiten erfindungsgemäßen Ausführung einer Gegenelektode,
Fig. 3 eine schematische Darstellung einer erfindungsgemäßen dritten Ausführung einer Gegenelektrode und in Fig. 4 eine schematische Darstellung einer erfindungsgemäßen vierten Ausführung einer Gegenelektrode.

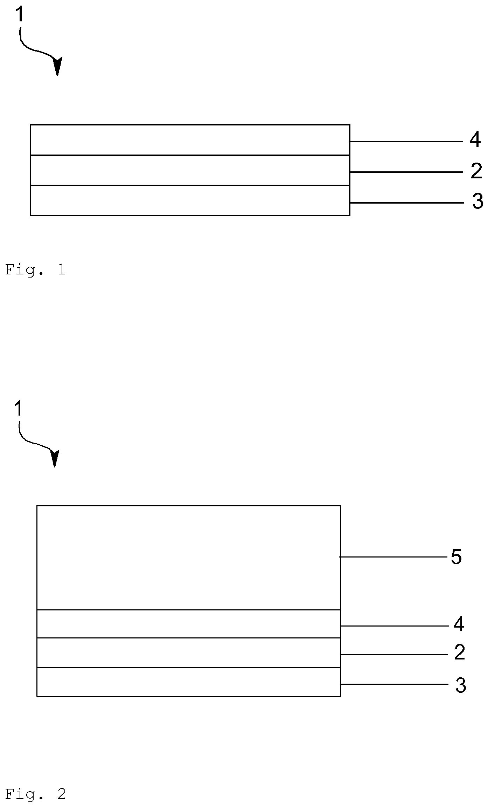

In einem Ausführungsbeispiel der Erfindung wird in Fig. 1 eine Gegenelektrode 1 dargestellt, welche eine erste Zwischenschicht 3 aus einem Metall oder Metalloxid, beispielsweise aus MoO₃, umfasst. Die erste Zwischenschicht 3 wird dabei durch thermisches Verdampfen auf einer organischen Schicht des Bauelements abgeschieden. Darauf wird eine erste Schicht 2 umfassend ein Metall, wie etwa Ag, abgeschieden. Die Abscheidung erfolgt dabei mittels Sputtern. Auf dieser ersten Schicht 2 wird eine zweite Schicht 4 als Entspiegelungsschicht angeordnet, welche beispielsweise N,N'-bis(naphthalen-1-yl)-N,N'-bis(phenyl)-benzidin umfasst.

In einem weiteren nicht näher dargestellten Ausführungsbeispiel der Erfindung umfasst die erfindungsgemäße Gegenelektrode 1 eine erste Zwischenschicht 3 aus einem Metall oder Metalloxid, beispielsweise aus MoO₃. Die erste Zwischenschicht 3 wird dabei durch thermisches Verdampfen auf einer organischen Schicht des Bauelements abgeschieden. Darauf wird eine erste Schicht 2 umfassend eine Metalllegierung, wie etwa Ag:Ca, abgeschieden. Die Abscheidung erfolgt dabei mittels Sputtern. Auf dieser ersten Schicht 2 wird eine zweite Schicht 4 als Entspiegelungsschicht angeordnet, welche beispielsweise N,N'-bis(naphthalen-1-yl)-N,N'-bis(phenyl)-benzidin umfasst.

In einem weiteren nicht näher dargestellten Ausführungsbeispiel der Erfindung umfasst die erfindungsgemäße Gegenelektrode 1 eine erste Zwischenschicht 3 aus einem Alkali- oder Erdalkalimetall, beispielsweise aus Ca. Die erste Zwischenschicht 3 wird dabei durch thermisches Verdampfen auf einer organischen Schicht des Bauelements abgeschieden. Darauf wird eine erste Schicht 2 umfassend eine Metalllegierung, wie etwa Ag:Ca, abgeschieden. Die Abscheidung erfolgt dabei mittels Sputtern. Auf dieser ersten Schicht 2 wird eine zweite Schicht 4 als Entspiegelungsschicht angeordnet, welche beispielsweise ZnS, ZnSe oder ZnTe umfasst.

In einem weiteren nicht näher dargestellten Ausführungsbeispiel der Erfindung umfasst die erfindungsgemäße Gegenelektrode 1 eine erste Zwischenschicht 3 aus einem Alkali- oder Erdalkalimetall, beispielsweise aus Mg. Die erste Zwischenschicht 3 wird dabei durch thermisches Verdampfen auf einer organischen Schicht des Bauelements abgeschieden. Darauf wird eine erste Schicht 2 umfassend eine Metalllegierung, wie etwa Ag:Mg, abgeschieden. Die Abscheidung erfolgt dabei mittels Sputtern. Auf dieser ersten Schicht 2 wird eine zweite Schicht 4 als Entspiegelungsschicht angeordnet, welche beispielsweise ZnS, ZnSe oder ZnTe umfasst.

In einem weiteren Ausführungsbeispiel ist in Fig. 2 eine weitere Ausgestaltung einer Gegenelektrodeg 1 dargestellt, welche den gleichen Aufbau, wie das vorhergehende Ausführungsbeispiel umfasst, wobei auf der zweiten Schicht 4 eine Kratzschutzschicht 5 angeordnet ist. Diese Kratzschutzschicht 5 kann beispielweise aus TiO₂ ausgeführt sein und eine Schichtdicke von 150nm haben.

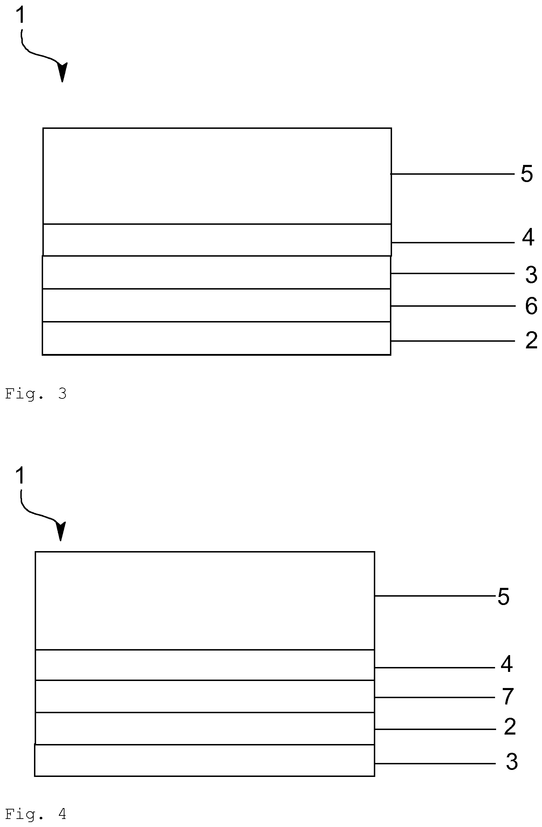

In einem weiteren Beispiel ist in Fig. 3 eine schematische Darstellung einer Gegenelektrode 1 dargestellt, welche eine erste Zwischenschicht 3 aus einem Metall oder Metalloxid, beispielsweise aus MoO₃, umfasst. Darauf angeordnet ist eine zweite Zwischenschicht 6 aus Nb₂O₅, welche eine Schichtdicke zwischen 5 bis 40 nm aufweist. Auf dieser zweite Zwischenschicht 6 ist die erste Schicht 3 aus einem Metall, wie etwa Ag, abgeschieden, wobei die Abscheidung durch Sputtern erfolgt. Auf dieser ersten Schicht 3 wird eine zweite Schicht 4 als Entspiegelungsschicht angeordnet, welche beispielsweise N,N'-bis(naphthalen-1-yl)-N,N'-bis(phenyl)-benzidin umfasst. Auf dieser zweiten Schicht 4 ist eine Kratzschutzschicht 5 angeordnet. Diese Kratzschutzschicht 5 kann beispielweise aus TiO₂ ausgeführt sein und eine Schichtdicke von 150nm haben.

In einem weiteren nicht näher dargestellten Ausführungsbeispiel umfasst eine Gegenelektrode 1 eine erste Zwischenschicht 3 aus einem Metall oder Metalloxid, beispielsweise aus MoO₃, umfasst. Darauf angeordnet ist eine zweite Zwischenschicht 6 aus Mg, welche eine Schichtdicke zwischen 5 bis 40 nm aufweist. Auf dieser zweiten Zwischenschicht 6 ist die erste Schicht 3 aus einer Metalllegierung, wie etwa Ag:Mg, abgeschieden, wobei die Abscheidung durch Sputtern erfolgt. Auf dieser ersten Schicht 3 wird eine zweite Schicht 4 als Entspiegelungsschicht angeordnet, welche beispielsweise ZnS umfasst. Auf dieser zweiten Schicht 4 ist eine Kratzschutzschicht 5 angeordnet. Diese Kratzschutzschicht 5 kann beispielweise aus TiO₂ ausgeführt sein und eine Schichtdicke von 150nm haben.

In einem weiteren nicht näher dargestellten Ausführungsbeispiel umfasst eine Gegenelektrode 1 eine erste Zwischenschicht 3 aus einem Metall oder Metalloxid, beispielsweise aus MoO₃, umfasst. Darauf angeordnet ist eine zweite Zwischenschicht 6 aus Ca, welche eine Schichtdicke zwischen 5 bis 40 nm aufweist. Auf dieser zweiten Zwischenschicht 6 ist die erste Schicht 3 aus einer Metalllegierung, wie etwa Ag:Ca, abgeschieden, wobei die Abscheidung durch Sputtern erfolgt. Auf dieser ersten Schicht 3 wird eine zweite Schicht 4 als Entspiegelungsschicht angeordnet, welche beispielsweise ZnSe umfasst. Auf dieser zweiten Schicht 4 ist eine Kratzschutzschicht 5 angeordnet. Diese Kratzschutzschicht 5 kann beispielweise aus TiO₂ ausgeführt sein und eine Schichtdicke von 150nm haben.

In einer nicht näher dargestellten Ausgestaltung des vorbeschriebenen Ausführungsbeispiels ist die zweite Zwischenschicht 6 aus aluminiumdotiertem Zinkoxid (AZO) ausgeführt. Die Schichtdicke kann hierbei zwischen 5 bis 40 nm betragen.

In einer weiteren nicht näher dargestellten Ausgestaltung des vorbeschriebenen Ausführungsbeispiels ist die zweite Zwischenschicht 6 aus Al ausgeführt. Die Schichtdicke kann hierbei zwischen 0,2 bis 3 nm betragen.

In einer nicht näher dargestellten Ausgestaltung des vorbeschriebenen Ausführungsbeispiels weist die Gegenelektrode 1 eine erste Zwischenschicht 3 auf, welche ein Metall oder Metalloxid, beispielsweise aus MoO₃, umfasst. Darauf angeordnet ist eine zweite Zwischenschicht 6 aus Nb₂O₅, welche eine Schichtdicke zwischen 5 bis 40 nm aufweist. Auf dieser zweiten Zwischenschicht 6 ist eine erste Schicht 3 aus einem Metall, wie etwa Ag, abgeschieden, wobei die Abscheidung durch Sputtern erfolgt. Auf dieser ersten Schicht 3 ist eine Kratzschutzschicht 5 angeordnet. Diese Kratzschutzschicht 5 kann beispielweise aus TiO₂ ausgeführt sein und eine Schichtdicke von 150nm haben.

In einem weiteren Beispiel ist in Fig. 4 eine schematische Darstellung einer Gegenelektrode 1 dargestellt, welche eine erste Zwischenschicht 3 aus einem Metall oder Metalloxid, beispielsweise aus MoO₃, umfasst. Auf dieser ersten Zwischenschicht 3 ist eine zweite Zwischenschicht 6 aus Nb₂O₅, welche eine Schichtdicke zwischen 5 bis 40 nm aufweist. Darauf ist eine erste Schicht 2 aus einem Metall, wie etwa Ag, angeordnet, wobei die Abscheidung der ersten Schicht 2 mittels Sputtern erfolgt. Auf dieser ersten Schicht 2 ist eine dritte Zwischenschicht 7, beispielsweise aus ITO, angeordnet. Die Schichtdicke dieser dritten Zwischenschicht 7 aus ITO beträgt zwischen 5 bis 40 nm. Auf dieser dritten Zwischenschicht 7 wird eine zweite Schicht 4 als Entspiegelungsschicht angeordnet, welche beispielsweise N,N'-bis(naphthalen-1-yl)-N,N'-bis(phenyl)-benzidin umfasst. Auf dieser zweiten Schicht 4 ist eine Kratzschutzschicht 5 angeordnet. Diese Kratzschutzschicht 5 kann beispielweise aus TiO₂ ausgeführt sein und eine Schichtdicke von 150nm haben.

In einer Ausgestaltung des vorbeschriebenen Beispiels ist die dritte Zwischenschicht 7 aus aluminiumdotiertem Zinkoxid AZO ausgeführt, wobei diese Zwischenschicht eine Schichtdicke zwischen 5 bis 40 nm aufwiest.

In einer weiteren nicht näher dargestellten Ausgestaltung des vorbeschriebenen Beispiels weist die Gegenelektrode 1 eine erste Zwischenschicht 3 auf, welche ein Metall oder Metalloxid, beispielsweise aus MoO₃, umfasst. Auf dieser ersten Zwischenschicht 3 ist eine zweite Zwischenschicht 6 aus Nb₂O₅, welche eine Schichtdicke zwischen 5 bis 40 nm aufweist. Darauf ist eine erste Schicht 3 aus einem Metall, wie etwa Ag, angeordnet, wobei die Abscheidung der ersten Schicht 2 mittels Sputtern erfolgt. Auf dieser ersten Schicht 2 ist eine dritte Zwischenschicht 7, beispielsweise aus ITO, angeordnet. Die Schichtdicke dieser dritten Zwischenschicht 7 aus ITO beträgt zwischen 5 bis 40 nm. Auf dieser dritten Zwischenschicht 7 ist eine Kratzschutzschicht 5 angeordnet. Diese Kratzschutzschicht 5 kann beispielweise aus TiO₂ ausgeführt sein und eine Schichtdicke von 150nm haben.

In einem weiteren nicht näher dargestellten Beispiel umfasst die Gegenelektrode 1 eine erste Zwischenschicht 3 aus einem Metall oder Metalloxid, beispielsweise aus MoO₃, umfasst. Auf dieser ersten Zwischenschicht 3 ist eine zweite Zwischenschicht 6 aus Nb₂O₅, welche eine Schichtdicke zwischen 5 bis 40 nm aufweist, angeordnet. Auf dieser zweiten Zwischenschicht 6 ist eine erste Zwischenschicht 2 aus einem Metall, wie etwa Ag, angeordnet, wobei die Abscheidung der ersten Schicht 2 mittels Sputtern erfolgt. Auf dieser ersten Schicht 2 ist eine dritte Zwischenschicht 7, beispielsweise aus ITO, angeordnet. Die Schichtdicke dieser dritten Zwischenschicht 7 aus ITO beträgt zwischen 5 bis 40 nm. Auf dieser dritten Zwischenschicht 7 wird eine zweite Schicht 4 als Entspiegelungsschicht angeordnet, welche beispielsweise N,N'-bis(naphthalen-1-yl)-N,N'-bis(phenyl)-benzidin umfasst. Auf dieser zweiten Schicht 4 ist eine Kratzschutzschicht 5 angeordnet. Diese Kratzschutzschicht 5 kann beispielweise aus TiO₂ ausgeführt sein und eine Schichtdicke von 150 nm haben.

In einem weiteren nicht näher dargestellten Ausführungsbeispiel umfasst die Gegenelektrode 1 eine erste Zwischenschicht 3 aus einem Metall oder Metalloxid, beispielsweise aus MoO₃, umfasst. Auf dieser ersten Zwischenschicht 3 ist eine zweite Zwischenschicht 6 aus Mg, welche eine Schichtdicke zwischen 5 bis 40 nm aufweist, angeordnet. Auf dieser zweiten Zwischenschicht 6 ist eine erste Schicht 2 aus einer Metalllegierung, wie etwa Ag:Mg, angeordnet, wobei die Abscheidung der ersten Schicht 2 mittels Sputtern erfolgt. Auf dieser ersten Schicht 2 ist eine dritte Zwischenschicht 7, beispielsweise aus Mg, angeordnet. Die Schichtdicke dieser dritten Zwischenschicht 7 aus Mg beträgt zwischen 5 bis 40 nm. Auf dieser dritten Zwischenschicht 7 wird eine zweite Schicht 4 als Entspiegelungsschicht angeordnet, welche beispielsweise ZnS, ZnSe oder ZnTe umfasst. Auf dieser zweiten Schicht 4 ist eine Kratzschutzschicht 5 angeordnet. Diese Kratzschutzschicht 5 kann beispielweise aus TiO₂ ausgeführt sein und eine Schichtdicke von 150 nm haben.

In einem weiteren nicht näher dargestellten Beispiel umfasst die Gegenelektrode 1 eine erste Zwischenschicht 3 aus einem Metall oder Metalloxid, beispielsweise aus MoO₃, umfasst. Auf dieser ersten Zwischenschicht 3 ist eine zweite Zwischenschicht 6 aus Nb₂O₅, welche eine Schichtdicke zwischen 5 bis 40 nm aufweist, angeordnet. Auf dieser zweiten Zwischenschicht 6 ist eine erste Schicht 2 aus einem Metall, wie etwa Ag, angeordnet, wobei die Abscheidung der ersten Schicht 2 mittels Sputtern erfolgt. Auf dieser ersten Schicht 2 ist eine dritte Zwischenschicht 7, beispielsweise aus ITO, angeordnet. Die Schichtdicke dieser dritten Zwischenschicht 7 aus ITO beträgt zwischen 5 bis 40 nm. Auf dieser dritten Zwischenschicht 7 wird eine Kratzschutzschicht 5 angeordnet. Diese Kratzschutzschicht 5 kann beispielweise aus TiO₂ ausgeführt sein und eine Schichtdicke von 150 nm haben.

### Bezugszeichenliste

1 Gegenelektrode
2 erste Schicht
3 erste Zwischenschicht
4 zweite Schicht
5 Kratzschutzschicht
6 zweite Zwischenschicht
7 dritte Zwischenschicht

## Patentansprüche

1. Optoelektronisches Bauelement auf einem Substrat umfassend eine erste und eine zweite Elektrode, wobei die erste Elektrode auf dem Substrat angeordnet ist und die zweite Elektrode eine Gegenelektrode bildet, wobei zwischen diesen Elektroden zumindest ein photoaktives Schichtsystem angeordnet ist, welches zumindest ein photoaktives Donor-Akzeptorsystem mit organischen Materialien und eine dotierte, teilweise dotierte oder undotierte Transportschicht, d.h. n- bzw. p-Schicht, umfasst, wobei die Gegenelektrode (1) zumindest eine erste Schicht (2) aufweist, die Gegenelektrode weiterhin eine erste Zwischenschicht (3) aus einem Alkali- oder Erdalkalimetall oder MoOx umfasst, wobei die erste Zwischenschicht (3) zwischen der ersten Schicht (2) und dem photoaktiven Schichtsystem des Bauelements angeordnet ist und die Gegenelektrode eine zweite Schicht (4) umfasst, welche auf der ersten Schicht (2) angeordnet ist und eine Schichtdicke zwischen 10 bis 100 nm aufweist, und die Transportschicht zwischen dem photoaktiven Schichtsystem und der Gegenelektrode angeordnet ist, **dadurch gekennzeichnet, dass** die erste Schicht eine Metalllegierung umfasst, welche Ag enthält und die zweite Schicht einen Brechungsindex n > 2,0 aufweist.

2. Bauelement nach Anspruch 1, **dadurch gekennzeichnet, dass** die erste Schicht (2) eine Legierung aus Ag und Ca oder Ag und Mg enthält.

3. Bauelement nach einem der vorhergehenden Ansprüche, **dadurch gekennzeichnet, dass** die erste Schicht (2) eine Legierung aus Ag und Ca oder Ag und Mg enthält, wobei der Anteil des Ag oder Ca oder Mg mindestens 30% beträgt.

4. Bauelement nach einem der vorhergehenden Ansprüche, **dadurch gekennzeichnet, dass** die erste Zwischenschicht (3) der Gegenelektrode eine Schichtdicke zwischen 0,1 bis 100 nm aufweist

5. Bauelement nach einem der vorhergehenden Ansprüche, **dadurch gekennzeichnet, dass** die erste Schicht (2) der Gegenelektrode (1) eine Schichtdicke zwischen 3 und 20 nm, vorzugsweise zwischen 5 bis 10 nm aufweist.

6. Bauelement nach einem der vorhergehenden Ansprüche, **dadurch gekennzeichnet, dass** die erste Zwischenschicht (3) Ca, Mg oder MoOₓ enthält.

7. Bauelement nach einem der vorhergehenden Ansprüche, **dadurch gekennzeichnet, dass** die zweite Schicht (4) ein Alkali- oder Erdalkalimetall, ein Metalloxid oder ein organisches Material umfasst.

8. Bauelement nach einem der Ansprüche 1 bis 7, **dadurch gekennzeichnet, dass** die zweite Schicht (4) ein Nitrid, Selenid, Sulfid, Oxid, Tellurid oder Polymer umfasst.

9. Bauelement nach einem der vorhergehenden Ansprüche, **dadurch gekennzeichnet, dass** die zweite Schicht (4) einen Brechungsindex > 2,2 aufweist.

10. Bauelement nach einem der vorhergehenden Ansprüche, **dadurch gekennzeichnet, dass** auf der zweiten Schicht (4) eine Schutzschicht (5) angeordnet ist, welche ein Metalloxid umfasst und eine Schichtdicke > 100 nm aufweist.

11. Bauelement nach einem der vorhergehenden Ansprüche, **dadurch gekennzeichnet, dass** zwischen der ersten Zwischenschicht (3) und der ersten Schicht (2) der Gegenelektrode eine zweite Zwischenschicht (6) aus einem Metall oder Metalloxid eingefügt ist, wobei die zweite Zwischenschicht (6) eine Schichtdicke zwischen 0,02 bis 40 nm, bevorzugt zwischen 0,05 bis 30 nm, aufweist.

12. Bauelement nach Anspruch 11, **dadurch gekennzeichnet, dass** die zweite Zwischenschicht (6) aus aluminiumdotierten Zinkoxid, Magnesium, Kalzium, oder Aluminium besteht.

13. Bauelement nach einem der vorhergehenden Ansprüche, **dadurch gekennzeichnet, dass** zwischen der ersten und der zweiten Schicht (2,4) der Gegenelektrode (1) eine weitere Zwischenschicht (7) aus einem Metall oder Metalloxid eingefügt ist.

14. Bauelement nach einem der vorhergehenden Ansprüche, **dadurch gekennzeichnet, dass** das Substrat opak oder transparent ausgeführt ist.

15. Bauelement nach einem der vorhergehenden Ansprüche, **dadurch gekennzeichnet, dass** das Substrat flexibel ausgeführt ist.

16. Bauelement nach einem der vorhergehenden Ansprüche, **dadurch gekennzeichnet, dass** das optoelektronische Bauelement eine organische Solarzelle ist.

17. Bauelement nach einem der vorhergehenden Ansprüche, **dadurch gekennzeichnet, dass** es sich bei dem Bauelement um eine Einzel-, Tandem- oder Mehrfachzelle handelt, **dadurch gekennzeichnet, dass** das photoaktive Schichtsysystem aus einer Kombination von nip, ni, ip, pnip, pni, pip, nipn, nin, ipn, pnipn, pnin oder pipn-Strukturen ausgeführt ist, bei der mehrere unabhängige Kombinationen, die mindestens eine i-Schicht enthalten, übereinandergestapelt sein können.

## Claims

1. An optoelectronic component on a substrate comprising a first and a second electrode, wherein the first electrode is arranged on the substrate and the second electrode forms a counter electrode, wherein between these electrodes at least one photoactive layer system is arranged which at least one photoactive donor-acceptor system with organic materials and a doped, partially doped or undoped transport layer, ie n- or player, wherein the counter electrode (1) has at least one first layer (2), the counter electrode further comprises a first intermediate layer (3) of an alkali or alkaline earth metal or MoOx, wherein the first intermediate layer (3) is arranged between the first layer (2) and the photoactive layer system of the component and the counter electrode comprises a second layer (4) which is arranged on the first layer (2) and has a layer thickness between 10 to 100 nm, and the transport layer is disposed between the photoactive layer system and the counter electrode, **characterized in that** the first layer comprises a metal alloy containing Ag and the second layer has a refractive index> 2.0.

2. Component according to claim 1, **characterized in that** the first layer (2) contains an alloy of Ag and Ca or Ag and Mg.

3. Component according to one of the preceding claims, **characterized in that** the first layer (2) contains an alloy of Ag and Ca or Ag and Mg, wherein the proportion of Ag or Ca or Mg is at least 30%.

4. Component according to one of the preceding claims, **characterized in that** the first intermediate layer (3) of the counter electrode has a layer thickness between 0.1 to 100 nm.

5. Component according to one of the preceding claims, **characterized in that** the first layer (2) of the counter electrode (1) has a layer thickness between 3 and 20 nm, preferably between 5 to 10 nm.

6. Component according to one of the preceding claims, **characterized in that** the first intermediate layer (3) contains Ca, Mg or MoOx.

7. Component according to one of the preceding claims, **characterized in that** the second layer (4) comprises an alkali or alkaline earth metal, a metal oxide or an organic material.

8. Component according to one of claims 1 to 7, **characterized in that** the second layer (4) comprises a nitride, selenide, sulfide, oxide, telluride or polymer.

9. Component according to one of the preceding claims, **characterized in that** the second layer (4) has a refractive index> 2.2.

10. Component according to one of the preceding claims, **characterized in that** on the second layer (4) a protective layer (5) is arranged, which comprises a metal oxide and has a layer thickness> 100 nm.

11. Component according to one of the preceding claims, **characterized in that** between the first intermediate layer (3) and the first layer (2) of the counter electrode, a second intermediate layer (6) made of a metal or metal oxide is arranged, wherein the second intermediate layer (6) has a layer thickness between 0.02 to 40 nm, preferably between 0.05 to 30 nm.

12. Component according to Claim 11, **characterized in that** the second intermediate layer (6) contains of aluminum-doped zinc oxide, magnesium, calcium or aluminum.

13. Component according to one of the preceding claims, **characterized in that** between the first and the second layer (2,4) of the counter electrode (1) is inserted a further intermediate layer (7) made of a metal or metal oxide.

14. Component according to one of the preceding claims, **characterized in that** the substrate is made opaque or transparent.

15. Component according to one of the preceding claims, **characterized in that** the substrate is made flexible.

16. Component according to one of the preceding claims, **characterized in that** the optoelectronic component is an organic solar cell.

17. Component according to one of the preceding claims, **characterized in that** the component is a single, tandem or multiple cell, **characterized in that** the photoactive coating system contains of a combination of nip, ni, ip, pnip, pni, pip, nipn, nin, ipn, pnipn, pnin, or pipn structures, where multiple independent combinations containing at least one i-layer may be stacked on top of each other.

## Revendications

1. Composant optoélectronique sur un substrat comprenant une première et une seconde électrodes, la première électrode étant agencée sur le substrat et la seconde électrode formant une contre-électrode, dans lequel entre au moins un système de couche photoactive est disposé, lequel système au moins un système donneur-accepteur photoactif avec des matériaux organiques et une couche de transport dopée, partiellement dopée ou non dopée, c. à d. couche n ou p, dans laquelle la contre-électrode (1) comporte au moins une première couche (2), la contre-électrode comprenant en outre une première couche intermédiaire (3) d'un métal alcalin ou alcalino-terreux ou de MoOx, dans laquelle la première couche intermédiaire (3) est disposé entre la première couche (2) et le système de couche photoactif du composant et la contre-électrode comprend une seconde couche (4) qui est disposée sur la première couche (2) et a une épaisseur de couche comprise entre 10 et 100 nm et la couche de transport est disposé entre le système de couche photoactif et la contre-électrode, **caractérisé en ce que** la première couche comprend un alliage métallique contenant Ag et que la deuxième couche a un indice de réfraction> 2,0.

2. Composant selon la revendication 1, **caractérisé en ce que** la première couche (2) contient un alliage de Ag et Ca ou Ag et Mg.

3. Composant selon l'une des revendications précédentes, **caractérisé en ce que** la première couche (2) contient un alliage de Ag et Ca ou Ag et Mg, dans lequel la proportion de Ag ou Ca ou Mg est d'au moins 30%.

4. Composant selon l'une des revendications précédentes, **caractérisé en ce que** la première couche intermédiaire (3) de la contre-électrode présente une épaisseur de couche comprise entre 0,1 et 100 nm.

5. Composant selon l'une des revendications précédentes, **caractérisé en ce que** la première couche (2) de la contre-électrode (1) a une épaisseur de couche comprise entre 3 et 20 nm, de préférence entre 5 et 10 nm.

6. Composant selon l'une des revendications précédentes, **caractérisé en ce que** la première couche intermédiaire (3) contient du Ca, du Mg ou du MoOx.

7. Composant selon l'une des revendications précédentes, **caractérisé en ce que** la deuxième couche (4) comprend un métal alcalin ou alcalino-terreux, un oxyde métallique ou un matériau organique.

8. Composant selon l'une des revendications 1 à 7, **caractérisé en ce que** la deuxième couche (4) comprend un nitrure, un séléniure, un sulfure, un oxyde, un tellurure ou un polymère.

9. Composant selon l'une des revendications précédentes, **caractérisé en ce que** la deuxième couche (4) a un indice de réfraction> 2,2.

10. Composant selon l'une des revendications précédentes, **caractérisé en ce qu'**une couche protectrice (5) est disposée sur la deuxième couche (4), qui comprend un oxyde métallique et a une épaisseur de couche> 100 nm.

11. Composant selon l'une des revendications précédentes, **caractérisé en ce qu'**une seconde couche intermédiaire (6) en métal ou en oxyde métallique est insérée entre la première couche intermédiaire (3) et la première couche (2) de la contre-électrode, dans laquelle la seconde couche intermédiaire (6) a une épaisseur. entre 0,02 et 40 nm, de préférence entre 0,05 et 30 nm.

12. Composant selon la revendication 11, **caractérisé en ce que** la deuxième couche intermédiaire (6) est constituée d'oxyde de zinc, de magnésium, de calcium ou d'aluminium dopé à l'aluminium.

13. Composant selon l'une des revendications précédentes, **caractérisé en ce qu'**une autre couche intermédiaire (7) en métal ou en oxyde métallique est insérée entre la première et la deuxième couche (2, 4) de la contre-électrode (1).

14. Composant selon l'une des revendications précédentes, **caractérisé en ce que** le substrat est rendu opaque ou transparent.

15. Composant selon l'une des revendications précédentes, **caractérisé en ce que** le substrat est rendu flexible.

16. Composant selon l'une des revendications précédentes, **caractérisé en ce que** le composant optoélectronique est une cellule solaire organique.

17. Composant selon l'une des revendications précédentes, **caractérisé en ce que** le composant est une cellule unique, en tandem ou multiple, **caractérisé en ce que** le système de revêtement photoactif consiste en une combinaison de nip, ni, ip, pnip, pni, pip, structures nipn, nin, ipn, pnipn, pnin ou pipn, dans lesquelles plusieurs combinaisons indépendantes contenant au moins une couche i peuvent être empilées les unes sur les autres.
